# EUROPÄISCHE PATENTSCHRIFT

(11) **EP 1 093 219 B1**
(45) Veröffentlichungstag und Bekanntmachung des Hinweises auf die Patenterteilung: **18.01.2006**
(21) Anmeldenummer: 00203417.1
(22) Anmeldetag: 02.10.2000
(51) Int. Cl.: H03D 1/22

(54) **Schaltungsanordnung zur Demodulation eines Zwischenfrequenz-Videosignals**
Circuit to demodulate an intermediate frequency video signal
Circuit pour démoduler un signal vidéo à fréquence intermédiaire

(30) Priorität: 09.10.1999 DE 19948745
(43) Veröffentlichungstag der Anmeldung: 18.04.2001
(73) Patentinhaber: Philips Intellectual Property & Standards GmbH, 20099 Hamburg (DE); Koninklijke Philips Electronics N.V., 5621 BA Eindhoven (NL)
(72) Erfinder: Brilka, Joachim, Philips Corporate I. P. GmbH, 52064 Aachen (DE); Hafemeister, Thomas, Philips Corporate I. P. GmbH, 52064 Aachen (DE)
(74) Vertreter: Volmer, Georg

(56) Entgegenhaltungen:
- EP-A- 0 141 466
- EP-A- 0 293 828
- EP-A- 0 757 483
- US-A- 4 598 319

## Beschreibung

Die Erfindung betrifft eine Schaltungsanordnung zur Demodulation eines Zwischenfrequenz-Videosignals mit einem Video-Demodulator und mit einem als Costas-Loop ausgebildeten Phasenregelkreis, wobei ein Ausgangssignal eines in der Costas-Loop vorgesehenen steuerbaren Oszillators und das Zwischenfrequenz-Videosignal auf den Video-Demodulator gekoppelt sind.

Schaltungsanordnungen zur Demodulation von Zwischenfrequenz-Videosignalen weisen im allgemeinen einen Phasenregelkreis zur Rückgewinnung der Modulationsfrequenz mit der richtigen Phasenlage auf. Konventionelle Phasenregelkreise, welche nur alle 360° einen stabilen Arbeitspunkt haben, reagieren auf Übermodulation des amplitudenmodulierten Fernseh-Bildträgers mit einem Phasensprung um 180°. Durch diese Phasenänderung wird übergangsweise der synchrone Zusammenhang zwischen der Phase des vom Phasenregelkreis gelieferten Signals und des Demodulators gestört. Es treten Bildstörungen auf.

Es ist ferner bekannt, für derartige Demodulatoren als Phasenregelkreis eine sogenannte Costas-Loop einzusetzen (siehe z.B. das Dokument US 4 598 319 A) welche sich dadurch auszeichnet, dass sie in Abständen von 180° stabile Arbeitspunkte aufweist. Dies hat zur Folge, dass bei Auftreten einer Übermodulation in einem Zwischenfrequenz-Videosignal die Costas-Loop auch auf die dann invertiert auftretende Trägerphase, also auf die um 180° bezüglich ihrer Phase veränderte Trägerphase des Fernsehbildträgers rasten kann. Es treten somit die oben beschriebenen Transientenstörungen nicht auf. Es tritt jedoch ein anderes Problem auf, dass durch die in Abständen von 180° stabilen Arbeitspunkte entsteht. Dieses besteht darin, dass beim Einrasten der Costas-Loop infolge ihrer stabilen Arbeitspunkte bei jeweils 180° Phasenabstand ein zufälliges Einrasten auf einen von zwei stabilen Zuständen im Abstand von 180° Phase möglich ist. Es ist daher bei Anwendung einer Costas-Loop in einem derartigen Modulator von vornherein nicht bekannt, mit welcher Polarität das demodulierte Videosignal auftritt. Costas-Loops an sich sind aus der Veröffentlichung "Phaselock Techniques" von Floyd M. Gardner, erschienen bei John Wiley & Sons, Seite 221, insbesondere Bild 11.6, bekannt.

Es ist Aufgabe der Erfindung, eine Schaltungsanordnung der eingangs genannten Art mit Costas-Loop anzugeben, welche das demodulierte Videosignal immer in einer gewünschten Polarität liefert.

Diese Aufgabe ist erfindungsgemäß dadurch gelöst, dass ein Polaritätsinverter vorgesehen ist, der dem Video-Demodulator nachgeschaltet ist und mittels dessen in Abhängigkeit eines von einem Polaritätsdetektor gelieferten Steuersignals die Polarität des demodulierten Videosignals invertierbar ist, und dass der Polaritätsdetektor die Polarität des Ausgangssignals des Video-Demodulators oder des Polaritätsinverters feststellt und in Abhängigkeit der festgestellten Polarität den Polaritätsinverter mittels des Steuersignals so ansteuert, dass das demodulierte Videosignal am Ausgang des Polaritätsinverters eine vorgegebene Polarität aufweist.

In der Schaltungsanordnung zur Demodulation eines Zwschenfrequenz-Videosignals ist ein Polaritätsinverter vorgesehen. Dieser ist dem Video-Demodulator nachgeschaltet und gestattet es, die Polarität des von dem Video-Demodulator gelieferten demodulierten Videosignals zu invertieren. Es kann also grundsätzlich mittels dieses Polaritätsinverters eine gewünschte Polarität des demodulierten Videosignals hergestellt werden.

Hierzu wird der Polaritätsinverter mittels eines Steuersignals gesteuert, das von einem Polaritätsdetektor geliefert wird.

Der Polaritätsdetektor stellt die Polarität des Ausgangssignals entweder des Video-demodulators oder des Polaritätsinverters fest und steuert den Polaritätsinverter in Abhängigkeit dieser festgestellten Polarität so, dass das demodulierte Videosignal am Ausgang des Polaritätsinverters eine vorgegebene Polarität aufweist.

Grundgedanke der Erfindung ist also, die tatsächliche Polarität des demodulierten Videosignals festzustellen und in Abhängigkeit dieser festgestellten Polarität den Polaritätsinverter so zu steuern, dass am Ausgang der Schaltungsanordnung das demodulierte Videosignal mit der gewünschten Polarität auftritt.

Damit ist unter allen Betriebsumständen der Schaltungsanordnung sichergestellt, dass die gewünschte Polarität auftritt.

Damit wird bei einem Auftreten einer Übermodulation in dem Videosignal und des dadurch auftretenden Phasensprungs in dem Bildträger am Ausgang der Schaltungsanordnung in dem demodulierten Videosignal weder eine Störung auftreten, noch wird eine Polaritätsinvertierung stattfinden. Ferner ist es in der erfindungsgemäßen Schaltungsanordnung gleichgültig, auf welchen von zwei um 180° versetzten Phasenarbeitspunkten die Costas-Loop einrastet; die Schaltungsanordnung wird dennoch immer das Videosignal in der gewünschten Polarität liefern.

Eine gemäß Anspruch 2 vorgesehene Ausgestaltung der Erfindung hat vor allem den Vorteil, dass dann, wenn der Polaritätsdetektor die Polarität des Ausgangssignals des Polaritätsinverters feststellt (und nicht die des Ausgangssignals des Demodulators) eine Art rückgekoppelte Lösung möglich ist, bei der im Polaritätsdetektor bei Auftreten der ungewünschten Polarität des demodulierten Videosignals nur einmalig eine Zustandsänderung des Steuersignals ausgelöst werden muß, da mit der dadurch ausgelösten Umschaltung des Polaritätsinverters das Videosignal an dessen Ausgang dann nachfolgend in der richtigen, gewünschten Polarität auftritt.

Dabei ist die Schaltungsanordnung vorteilhaft wie gemäß einer weiteren Ausgestaltung nach Anspruch 3 vorgesehen so ausgelegt, dass das demodulierte Videosignal mit negativer Polarität auftritt. Das demodulierte Videosignal wird üblicherweise in bekannten Schaltungsanordnungen in dieser Polarität verarbeitet.

Die oben beschriebene einmalige Reaktion des Polaritätsdetektors bei Auftreten einer ungewünschten Polarität kann vorteilhaft, wie gemäß einer weiteren Ausgestaltung der Erfindung nach Anspruch 4 vorgesehen ist, mittels eines Komparators und eines D-Flipflops erzielt werden. Der Komparator liefert dann, wenn das ihm zugeführte Videosignal betragsmäßig den Wert eines Vergleichssignals überschreitet, einen entsprechenden Impuls an das D-Flipflop. Auf diesen Impuls hin ändert das D-Flipflop seinen Schaltzustand und somit das Steuersignal seinen Zustand. Daraufhin schaltet der Polaritätsinverter um und das demodulierte Videosignal tritt hinter dem Polaritätsinverter nunmehr in der gewünschten Polarität auf. Daher wird nachfolgend durch den Komparator kein Schaltimpuls mehr ausgelöst.

Dabei weist die Vergleichsspannung gemäß Anspruch 5 vorteilhaft etwa den halben Wert der Spannung auf, die in dem Videosignal bei maximaler Modulation auftritt. Dies gilt sowohl für positive wie auch für negative Polarität.

Für Multinorm-Fernsehempfänger, in denen meist ohnehin festgestellt oder vorgegeben wird, welcher Modulationsart das Zwischenfrequenz-Videosignal ist, kann vorteilhaft gemäß Anspruch 7 dieses Modulationsart-Signal auch dazu verwendet werden, den Polaritätsdetektor die Modulationsart mitzuteilen und entsprechend den Polaritätsinverter zu steuern. Es kann damit erreicht werden, dass sowohl bei negativer Modulation wie auch bei positiver Modulation die Schaltungsanordnung beispielsweise immer ein demoduliertes Videosignal negativer Polarität aufweist. Dies ist ein weiterer wesentlicher Vorteil der Schaltungsanordnung gemäß der Erfindung, da sie auf diese Weise neben den oben beschriebenen Vorteilen auch dazu eingesetzt werden kann, die Polarität eines Fernsehsignals dann zu ändern, wenn dieses aufgrund positiver oder negativer Modulation seine Polarität wechselt. Auch dieser Polaritätswechsel kann durch die erfindungsgemäße Schaltungsanordnung unterdrückt werden.

Zu diesem Zwecke sind vorteilhaft gemäß einer weiteren Ausgestaltung der Erfindung die Maßnahmen gemäß Anspruch 8 vorgesehen. Durch den schaltbaren Inverter kann je nach Modulationsart des Videosignals das den Polaritätsdetektor zugeführte, demodulierte Videosignal bezüglich seiner Polarität invertiert werden oder nicht. Damit wird im Ergebnis erreicht, dass der Polaritätsdetektor den Polaritätsinverter immer so schaltet, dass an dessen Ausgang das demodulierte Videosignal mit einer festen, gewünschten Polarität erscheint, welche unabhängig davon ist, welcher Modulationsart das Zwischenfrequenz-Videosignal war.
Darüber hinaus wird mittels des Videoverstärkers eine je nach Modulationsart variierende Gleichspannungslage des demodulierten Videosignals ausgeglichen.

Alternativ besteht auch die Möglichkeit, wie gemäß einer weiteren Ausgestaltung der Erfindung nach Anspruch 9 vorgesehen ist, anstelle des schaltbaren Inverters die Vergleichsspannung des Komparators in Abhängigkeit der Modulationsart des Zwischenfrequenz-Videosignals zu verändern.

Nachfolgend wird ein Ausführungsbeispiel der Erfindung anhand der Zeichnung näher erläutert. Es zeigen:
Fig. 1 ein Blockschaltbild einer erfindungsgemäßen Schaltungsanordnung zur Demodulation eines Zwischenfrequenz-Videosignals mit einer Costas-Loop,
Fig. 2 ein Blockschaltbild eines Polaritätsdetektors der Schaltungsanordnung gemäß Fig. 1 und
Fig. 3 einige über der Zeit aufgetragene, demodulierte Videosignale zur Erläuterung der Arbeitsweise des Polaritätsdetektors und des Polaritätsinverters der Schaltungsanordnung gemäß Figur 1 bzw. Figur 2.

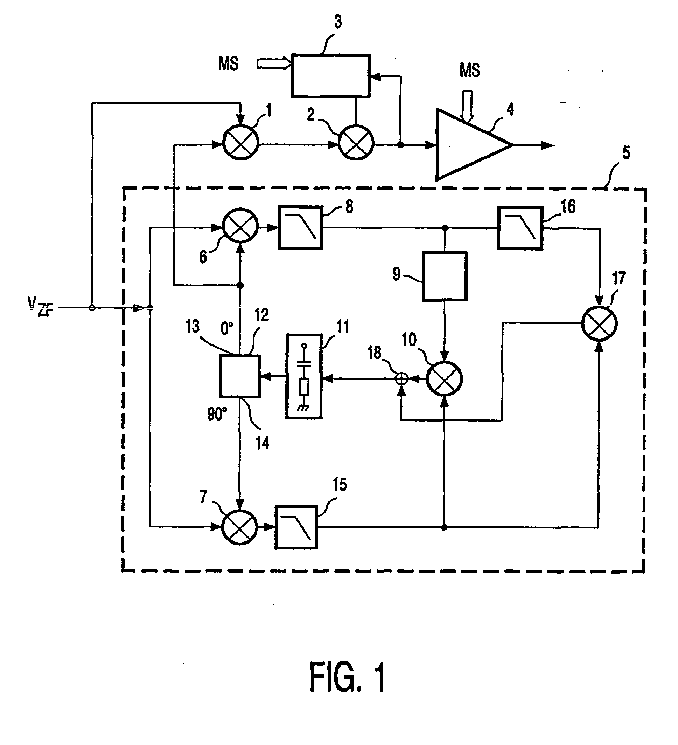

Fig. 1 zeigt in Form eines Blockschaltbildes eine erfindungsgemäße Schaltungsanordnung zur Demodulation eines Zwischenfrequenz-Videosignals, welche einen Video-Demodulator 1 aufweist, dem das Zwischenfrequenz-Videosignal V_{ZF} zugeführt wird. Die Modulationsfrequenz und Oszillatorfrequenz erhält der Video-Demodulator 1 von einer weiten unten zu erläutertenden Costas-Loop 5, welche als Phasenregelkreis dient.

Dem Video-Demodulator 1 ist ein Polaritätsinverter 2 nachgeschaltet, welcher mittels eines Steuersignals von einem Polaritätsdetektor 3 angesteuert wird. Der Polaritätsdetektor 3 erhält das Ausgangssignal des Polaritäsinverters 2 sowie ein die Demodulationsart des Zwischenfrequenz-Videosignals V_{ZF} angebendes Modulationsartsignal MS.
Dem Polaritätsinverter 2 ist ein Video-Verstärker 4 nachgeschaltet, dessen Gleichspannungsverstärkung in Abhängigkeit des Modulationsartsignals MS veränderbar ist. Somit ist der Gleichspannungswert in dem Ausgangssignal des Verstärkers 4 einstellbar.

Der Video-Verstärker 4 liefert ausgangsseitig das Ausgangssignal der erfindungsgemäßen Schaltungsanordnung, also das demodulierte Videosignal in einer gewünschten Polarität.

Die Costas-Loop 5 erhält eingangsseitig ebenfalls das Zwischenfrequenz-Videosignal V_{ZF}, das zwei in ihr vorgesehenen Mischern 6 und 7 zugeführt wird.

Dem ersten Mischer 6 ist ein erstes Tiefpaßfilter 8 nachgeschaltet, dem seinerseits ein Begrenzer 9 nachgeschaltet ist, dessen Ausgangssignal auf einen ersten Multiplizierer 10 geführt ist. Das Ausgangssignal des ersten Multiplizierers 10 gelangt auf ein Schleifenfilter 11, dem ein steuerbarer Oszillator 12 nachgeschaltet ist. Der steuerbare Oszillator 12 liefert einem ersten Ausgang ein Signal mit der Phasenlage Null, welches dem Video-Demodulator 1 zugeführt wird. An einem zweiten Ausgang 14 liefert der steuerbare Oszillator ein gegenüber dem ersten Eingang 1 um 90° in seiner Phase verschobenes Ausgangssignal, welches auf den zweiten Mischer 7 gelangt. Dem zweiten Mischer 7 ist ein zweites Tiefpaßfilter 15 nachgeschaltet, dessen Ausgangssignal auf den ersten Multiplizierer 10 gelangt.

Die grundsätzliche Arbeitsweise einer derartigen Costas-Loop ist aus der eingangs genannten Veröffentlichung bekannt. Der erste Mischer 6, das erste Tiefpaßfilter 8 sowie der Begrenzer 9 bilden in der Costas-Loop einen sogenannten I-Arm, wohingegen der zweite Mischer 7 und das zweite Tiefpaßfilter 15 einen sogenannten Q-Arm bilden. Der Q-Arm ist derjenige, welcher wie eine normale PLL arbeitet. Der I-Arm liefert ein Signal, welches gegenüber dem Signal des Q-Arms in Quadratur auftritt. Damit wird die Spannung des Q-Arms in dem ersten Multiplizierer 10 immer dann invertiert, wenn die Polarität des vom Q-Arm gelieferten Signals invertiert. Dies tritt immer dann ein, wenn die Modulation ihr Vorzeichen verändert, wenn also die Costas-Loop auf einen um 180° versetzten Arbeitspunkt regelt. Im Ergebnis wird somit mit diesem Aufbau der Costas-Loop erreicht, dass diese um 180° zueinander versetzte stabile Arbeitspunkte aufweist

Somit kann die Costas-Loop auch dann weiter stabil auf die Modulationsfrequenz eines ihr zugeführten Zwischenfrequenz-Videosignals regeln, wenn die Phasenlage dieser Modulationsfrequenz infolge einer Übermodulation um 180° springt. Die Costas-Loop rastet bei einem solchen Sprung auf die neue, um 180° versetzte Phasenlage augenblicklich ein. Es treten keine oder jedenfalls keine wesentlichen Transientenübergänge auf. Es tritt der Effekt ein, dass das an dem ersten Ausgang 13 des steuerbaren Oszillators 12 abgegriffene Signal, das dem Video-Demodulator 1 zugeführt wird, während der Zeiten, in denen Übermodulation auftritt, um 180° in seiner Phasenlage gegenüber dem Modulationssignal versetzt ist.

In der Costas-Loop ist ferner ein drittes Tiefpaßfilter 16 sowie ein zweiter Multiplizierer 17 vorgesehen, dem einerseits das Ausgangssignal des dritten Tiefpaßfilters 16 sowie dasjenige des zweiten Tiefpaßfilters 15 des Q-Arms zugeführt werden. Das Ausgangssignal des zweiten Multiplizierers 17 und des ersten Multiplizierers 10 werden mittels einer Überlagerungsstufe 18 miteinander überlagert und dem Schleifenfilter 11 zugeführt.

Die Elemente 16 und 17 bilden eine Art Frequenzdetektor, welche dazu dient, die Arbeitsfrequenz der Costas-Loop und somit auch des steuerbaren Oszillators 12 bei einer relativ großen Frequenzabweichung zu der Modulationsfrequenz an diese heranzuführen. Sie liefert nämlich ein frequenzabhängiges Signal, welches unabhängig von der Phasenlage bei einer Frequenzabweichung die Arbeitsfrequenz der Costas-Loop nachsteuert.

Wie oben erläutert, kann die Costas-Loop 5 auf einen um 180° versetzten arbeitspunkt rasten. Für das Ausgangssignal des Video-Demodulators 1 hat dies zur Folge, dass dieses eine unerwünschte Polarität aufweist. Dies soll durch die erfindungsgemäße Schaltungsanordnung vermieden werden.

Dazu sind der Polaritätsinverter 2 und der Polaritätsdetektor 3 vorgesehen. Mittels des Polaritätsinverters 2 kann die Polarität des ihm zugeführten demodulierten Videosignals invertiert werden. Dies geschieht in Abhängigkeit des Steuersignals, das vom Polaritätsdetektor 3 geliefert wird. Der Polaritätsdetektor 3 stellt die Polarität des Ausgangssignals des Polaritätsinverters 2 fest und steuert diesen in Abhängigkeit des Steuersignals so, dass dieses Ausgangssignal immer eine gewünschte Polarität, beispielsweise eine negative Polarität, aufweist.

Damit liefert der Ausgang des Polaritätsinverters 2 immer ein demoduliertes Videosignal mit der gewünschten Polarität.

Die Polarität des Ausgangssignals der Schaltungsanordnung bzw. des Polaritätsinverters 2 ist somit unabhängig davon auf welchen von zwei um 180° zueinander versetzten Arbeitspunkten die Costas-Loop 5 gerastet hat.

Die in dem Ausführungsbeispiel gemäß Fig. 1 dargestellte erfindungsgemäße Schaltungsanordnung ist darüber hinaus dazu geeignet, Zwischenfrequenz-Videosignale verschiedener Modulationsarten zu verarbeiten. Es können grundsätzlich derartige Signale positiver oder negativer Modulation auftreten. Um auch für derartige Signale, welche am Ausgang des Videodemodulators 1 bzw. am Ausgang des Polaritätsinverters 2 je nach Modulationsart verschiedene Polarität aufweisen, immer sicherzustellen, dass ausgangsseitig die gewünschte Polarität herrscht, wird dem Polaritätsdetektor 3 ein die Modulationsart angebendes Modulationsartsignal MS zugeführt. In Abhängigkeit dieses Siganls berücksichtigt der Polaritätsdetektor 3 bei der Generierung des Steuersignals die auftretende Modulationsart. Somit wird erreicht, dass unabhängig von der Modulationsart das demodulierte Videosignal am Ausgang des Polaritätsinverters 2 immer eine gewünschte Polarität aufweist.

Da dennoch diese Signale aufgrund ihrer verschiedenen Modulationsart einen differierenden Gleichspannungswert aufweisen, wird das Modulationsartsignal MS ferner einem Verstärker 4 zugeführt, welcher das Ausgangssignal des Polaritätsinverters 2 durch eine in Abhängigkeit des Modulationsartsignals MS einstellbare Gleichspannungsverstärkung so verstärkt, dass ausgangsseitig immer ein Videosignal mit etwa gleichem Gleichspanungswert auftritt.

Im Ergebnis ist somit erreicht worden, dass die erfindungsgemäße Schaltungsanordnung nicht nur bei Übermodulation, sondern auch bei Zwischenfrequenz-Videosignalen verschiedener Modulationsart ausgangsseitig ohne Transientenstörungen immer ein demoduliertes Videosignal einer gewünschten Polarität und mit einer festen Gleichspannungslage liefert.

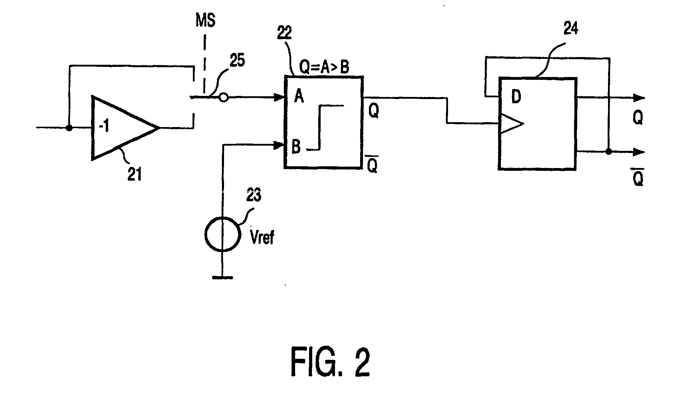

Die Fig. 2 zeigt in detaillierterer Form Schaltungselemente des Polaritätsdetektors 3 der Schaltungsanordnung gemäß Fig. 1

Das Ausgangssignal des Polaritätsinverters 2 der Anordnung gemäß Fig. 1 wird innerhalb des Polaritätsdetektors 3 in der detaillierten Darstellung gemäß Fig. 2 einerseits einem Inverter 21 und andererseits einem Schalter 25 zugeführt. Dieser Schalter 25 wird in Abhängigkeit des Modulationsartsignals MS so umgeschaltet, dass er bei positiver Modulationsart des Zwischenfrequenz-Videosignals auf den Ausgang des Inverters 21 und bei negativer Modulationsart auf das Eingangssignal des Polaritätsdetektors geschaltet ist. Somit wird also das dem Polaritätsdetektor 3 zugeführte Ausgangssignal des Polaritätsinverters 2 dann mittels des Inverters 21 invertiert, wenn das Zwischenfrequenz-Videosigna positive Modulationsart hat. Hat es negative Modulationsart, so wird das Ausgangssignal des Polaritätsinverters 2 nicht invertiert.

Dem Schalter 25 ist ein Komparator 22 nachgeschaltet, an dessen Eingang A das von dem Schalter 25 gelieferte Signal geführt ist. Einem zweiten Eingang B des Komparators 22 wird ein Vergleichssignal Vref zugeführt, das von einer Spannungsquelle 23 geliefert wird. Der Komparator 22 liefert an seinem Ausgang Q dann ein Ausgangssignal, wenn das an seinem ersten Eingang A von dem Schalter 25 kommende Signal größer ist als das seinem zweiten Eingang B zugeführte Vergleichssignal Vref.

Das an dem Q-Ausgang des Komparators 22 erscheinende Signal wird einem Schalteingang eines nachgeschalteten D-Flipflops 24 zugeführt, dessen Ausgangssignal Q' auf den D-Eingang dieses D-Flipflops 24 rückgekoppelt ist. Damit wird erreicht, dass das D-Flipflop 24 seinen Schaltzustand dann ändert, wenn in dem Ausgangssignal Q des Komparators 22 ein Low-High-Übergang auftritt, also in der Übergangszone, in der der Komparator 22 feststellt, dass das Eingangssignal an seinem Eingang A größer ist als das an seinem Eingang B.

Das Ausgangssignal Q des D-Flipflops 24 stellt das Steuersignal dar, das in der Schaltungsanordnung gemäß Fig. 1 der Polaritätsinverter 2 zugeführt wird.

Im Ergebnis wird damit erreicht, dass das Steuersignal, das dem Polaritätsinverter 2 zugeführt wird, immer dann eine Änderung der Polarität des Polaritätsinverters 2 vorgibt, wenn der Komparator 22 feststellt, dass das Videosignal in seiner Amplitude das Vergleichssignal Vref überschreitet. Wird der Wert des Vergleichssignals so gelegt, dass ein Überschreiten seines Wertes nur dann eintritt, wenn ein Signal unerwünschter Polarität auftritt, so ist das Ziel der erfindungsgemäßen Schaltungsanordnung erreicht; es wird dann nämlich immer bei falscher Polarität des demodulierten Videosignals am Ausgang des Polaritätsinverters 2 das Steuersignal so umgeschaltet, dass dieses Ausgangssignal wieder die gewünschte Polarität aufweist.

Dies wird im folgenden anhand einiger Ausschnitte von Videosignalen näher erläutert, die über der Zeit dargestellt sind.

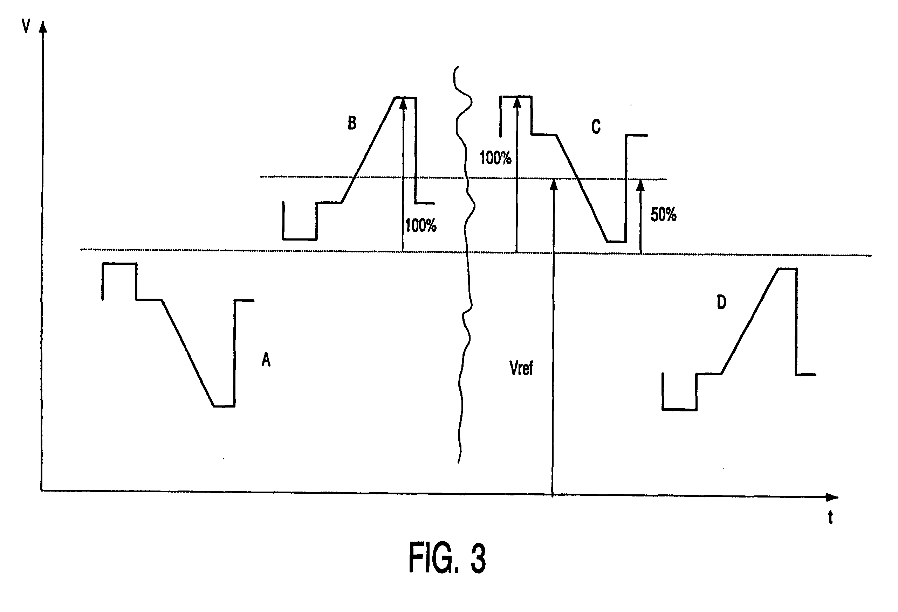

Die Darstellung gemäß Fig. 3 zeigt vier Schwingungszüge A, B, C und D von demodulierten Videosignalen verschiedener Polarität und verschiedener Modulationsart. Die Schwingungszüge A und B stellen solche eines demodulierten Videosignals dar, das aus einem Zwischenfrequenz-Videosignal mit positiver Modulationsart gewonnen wurde. Dabei zeigt der Schwingungszug A des demodulierten Videosignals wie er beispielsweise am Ausgang des Video-Demodulators 1 bzw. auch Polaritätsinverters 2 der Schaltungsanordnung gemäß Fig. 1 (bzw. am Eingang des Komparators 22 der Fig.3) auftreten kann. Dieser Schwingungszug zeigt in gewünschter Weise negative Polarität.

Beispielsweise durch Rasten der Costas -Loop 5 auf einennum 180° verschobenen Arbeitspunkt kann jedoch der Fall eintreten, dass das demodulierte Videosignal eine unerwünschte positive Polarität aufweist, wie dies in dem Schwingungszug B der Fig. 3 angedeutet ist.

In der Fig. 3 ist die Vergleichsspannung Vref des Phasendetekors gemäß Fig. 2 eingetragen. Die Fig. 3 zeigt, dass der Schwingungszug des Videosignals B, welches eine ungewünschte Polarität aufweist, zeitweise das Vergleichssignal Vref überschreitet. In der Anordnung gemäß Fig. 2 hätte dies zur Folge, dass in dem Ausgangssignal Q des Komparators 22 ein Low-High-Übergang auftritt, der wiederum ein Umschalten des Zustandes des D-FlipFlops 24 zur Folge hätte. Damit würde das Steuersignal, das in der Anordnung gemäß Fig. 1 dem Polaritätsinverter 2 zugeführt wird, entsprechend umgeschaltet. Dies wiederum hätte zur Folge, dass der Polaritätsinverter umgeschaltet wird und die Polarität des ihm zugeführten demodulierten Videosignals invertiert. Somit würde nach diesem Umschaltvorgang am Ausgang des Polaritätsinverters 2 wieder das Videosignal mit der gewünschten Polarität entsprechend dem Schwingungszug A in Fig. 3 auftreten. Es würde also durch das einmalige Überschreiten der Vergleichsspannung Vref durch den Schwingungszug B ein derartiger Umschaltvorgang ausgelöst, der zur Folge hätte, dass nachfolgend das Videosignal wieder mit der gewünschten Polarität entsprechend dem Schwingungszug A auftritt.

Die Fig. 3 zeigt ferner zwei Schwingungszüge C und D, die demodulierte Videosignale eines Zwischenfrequenz-Videosignals in negativer Modulation darstellen.

Da in der Schaltungsanordnung gemäß Fig. 2 der Inverter 21 nur bei solchen Zwischenfrequenz-Videosignalen aktiv ist, die positive Modulationsart aufweisen, treten die Signale C und D, die demodulierten Videosignale eines Zwischenfrequenz-Videosignals negativer Modualionsart entstammen, in umgekehrter Polarität auf. Der Schwingungszug D zeigt das demodulierte Zwischenfrequenz-Videosignal gewünschter negativer Polarität eines Zwischenfrequenz-Videosignals mit negativer Modulation. Hingegen zeigt der Schwingungszug C ein demoduliertes Videosignal unerwünschter positiver Polarität. Auch hier gilt wieder, dass ein Überschreiten der Vergleichsspannung Vref durch das Signal des Schwingungszuges C ein Umschalten des D-Flipflops 24 und damit des von ihm gelieferten Steuersignals auslöst, so dass der Polaritätsinverter 2 eine Invertierung des ihm zugeführten demodulierten Videosignals vornimmt, so dass das Signal wieder in der gewünschten negativen Polarität entsprechend zu D auftritt.

Im Ergebnis wird durch die erfindungsgemäße Schaltungsanordnung erreicht, dass das von ihr gelieferte demodulierte Videosignal immer eine gewünschte Polarität aufweist ohne Transientenstörungen bei einer eventuellen, in dem Zwischenfrequenz-Videosignal auftretenden Übermodulation. Es ist ferner unabhängig davon, auf welchen von zwei um 180° versetzten Arbeitspunkten Costas-Loop rastet. Darüber hinaus kann sogar eine Anpassung an die verschiedene Modulationsart des Zwischenfrequenz-Videosignals vorgesehen sein, so dass die Polarität des gelieferten demodulierten Videosignals sogar von der Modulationsart unabhängig ist.

## Patentansprüche

1. Schaltungsanordnung zur Demodulation eines Zwischenfrequenz-Videosignals mit einem Video-Demodulator (1) und mit einem als Costas-Loop ausgebildeten Phasenregelkreis (5), wobei ein Ausgangssignal eines in der Costas-Loop vorgesehenen steuerbaren Oszillators (12) und das Zwischenfrequenz-Videosignal auf den Video-Demodulator (1) gekoppelt sind,
**dadurch gekennzeichnet,**
**dass** ein Polaritätsinverter (2) vorgesehen ist, der dem Video-Demodulator (1) nachgeschaltet ist und mittels dessen in Abhängigkeit eines von einem Polaritätsdetektor (3) gelieferten Steuersignals die Polarität des demodulierten Videosignals invertierbar ist,
und **dass** der Polaritätsdetektor (3) die Polarität des Ausgangssignals des Video-Demodulators (1) oder des Polaritätsinverters (2) feststellt und in Abhängigkeit der festgestellten Polarität den Polaritätsinverter (2) mittels des Steuersignals so ansteuert, dass das demodulierte Videosignal am Ausgang des Polaritätsinverters (2) eine vorgegebene Polarität aufweist.

2. Schaltungsanordnung nach Anspruch 1,
**dadurch gekennzeichnet,**
**dass** der Polaritätsdetektor (3) die Polarität des Ausgangssignals des Polaritätsinverters (2) feststellt.

3. Schaltungsanordnung nach Anspruch 1 oder 2,
**dadurch gekennzeichnet,**
**dass** der Polaritätsdetektor (3) den Polaritätsinverter (2) so ansteuert,
**dass** das Ausgangssignal des Polaritätsinverters (2) eine negative Polarität aufweist.

4. Schaltungsanordnung nach Anspruch 2,
**dadurch gekennzeichnet,**
**dass** der Polaritätsdetektor (3) einen Komparator (22) aufweist, der dann, wenn das ihm zugeführte Videosignal betragsmäßig den Wert eines dem Komparator (22) zugeführten Vergleichssignals überschreitet, einen Impuls an ein D-Flip-Flop (24) gibt, welches auf diesen Impuls hin seinen Schaltzustand ändert, in Abhängigkeit dessen das Steuersignal generiert wird.

5. Schaltungsanordnung nach Anspruch 4,
**dadurch gekennzeichnet,**
**dass** die Vergleichsspannung etwa den halben Wert der bei maximaler Modulation in einem Videosignal unerwünschter Polarität auftretenden Spannung aufweist.

6. Schaltungsanordnung nach Anspruch 1 oder 2,
**dadurch gekennzeichnet,**
**dass** der Polaritätsinverter (3) als Multiplizierer ausgebildet ist.

7. Schaltungsanordnung nach Anspruch 1 oder 2,
**dadurch gekennzeichnet,**
**dass** der Anordnung ein Modulationsart-Signal zugeführt wird, welches angibt, ob das Videosignal positiv oder negativ moduliert ist und
**dass** der Polaritätsdetektor (3) das Steuersignal unter Berücksichtigung der Modulationsart generiert.

8. Schaltungsanordnung nach den Ansprüchen 4 und 7,
**dadurch gekennzeichnet,**
**dass** das Videosignal in dem Polaritätsdetektor (3) einem schaltbaren Inverter (21;25) zugeführt wird, welcher in Abhängigkeit des Modulationsart-Signals angesteuert wird und dessen Ausgangssignal auf den Komparator (22) gekoppelt ist und
**dass** dem Polaritätsinverter (2) ein Video-Verstärker (4) nachgeschaltet ist, dessen Gleichspannungsverstärkung in Abhängigkeit des Modulationsart-Signals veränderbar ist.

9. Schaltungsanordnung nach den Ansprüchen 4 und 7,
**dadurch gekennzeichnet,**
**dass** der Wert der Vergleichsspannung in Abhängigkeit des Wertes des Modulationsart-Signals verändert wird und dass dem Polaritätsinverter (2) ein Video-Verstärker (4) nachgeschaltet ist, dessen Gleichspannungsverstärkung in Abhängigkeit des Modulationsart-Signals veränderbar ist.

10. Schaltungsanordnung nach den Ansprüchen 2, 3, 4, 5 und 8,
**dadurch gekennzeichnet,**
**dass** die Vergleichsspannung eine positive Polarität aufweist und dass das Ausgangssignal des Polaritätsinverters (2) vor Kopplung auf den Komparator (22) nur dann mittels des schaltbaren Inverters (21) invertiert wird, wenn das Modulationsart-Signal ein positiv moduliertes Videosignal indiziert.

## Claims

1. A circuit arrangement for demodulating an intermediate-frequency video signal, comprising a video demodulator (1) and a phase-locked loop (5) formed as a Costas loop, in which an output signal of a controllable oscillator (12) arranged in the Costas loop and the intermediate-frequency video signal are coupled to the video demodulator (1), **characterized in that** a polarity inverter (2) is provided, which is preceded by the video demodulator (1) and by means of which the polarity of the demodulated video signal is invertible in dependence upon a control signal supplied by a polarity detector (3), and **in that** the polarity detector (3) determines the polarity of the output signal of the video demodulator (1) or of the polarity inverter (2) and, in dependence upon the determined polarity, controls the polarity inverter (2) by means of the control signal in such a way that the demodulated video signal at the output of the polarity inverter (2) has a predetermined polarity.

2. A circuit arrangement as claimed in claim 1, **characterized in that** the polarity detector (3) determines the polarity of the output signal of the polarity inverter (2).

3. A circuit arrangement as claimed in claim 1 or 2, **characterized in that** the polarity detector (3) controls the polarity inverter (2) in such a way that the output signal of the polarity inverter (2) has a negative polarity.

4. A circuit arrangement as claimed in claim 2, **characterized in that** the polarity detector (3) comprises a comparator (22) which supplies a pulse to a D-flipflop (24) when the value of the video signal supplied to said polarity detector exceeds the value of a comparison signal applied to the comparator (22), said D-flipflop changing, in response to said pulse, its switching state in dependence upon which the control signal is generated.

5. A circuit arrangement as claimed in claim 4, **characterized in that** the comparison voltage has approximately half the value of the voltage occurring at a maximum modulation in a video signal of the unwanted polarity.

6. A circuit arrangement as claimed in claim 1 or 2, **characterized in that** the polarity inverter (3) is formed as a multiplier.

7. A circuit arrangement as claimed in claim 1 or 2, **characterized in that** the arrangement receives a modulation-type signal indicating whether the video signal is modulated positively or negatively, and **in that** the polarity detector (3) generates the control signal while taking the modulation type into account.

8. A circuit arrangement as claimed in claims 4 and 7, **characterized in that** the video signal in the polarity detector (3) is applied to a switchable inverter (21; 25) which is controlled in dependence upon the modulation-type signal and whose output signal is coupled to the comparator (22), and **in that** the polarity inverter (2) precedes a video amplifier (4) whose DC gain is changeable in dependence upon the modulation-type signal.

9. A circuit arrangement as claimed in claims 4 and 7, **characterized in that** the value of the comparison voltage is changed in dependence upon the value of the modulation-type signal, and **in that** the polarity inverter (2) precedes a video amplifier (4) whose DC gain is changeable in dependence upon the modulation-type signal.

10. A circuit arrangement as claimed in claims 2, 3, 4, 5 and 8, **characterized in that** the comparison voltage has a positive polarity, and **in that** the output signal of the polarity inverter (2), before being coupled to the comparator (22), is inverted by means of the switchable inverter (21) only when the modulation-type signal indicates a positively modulated video signal.

## Revendications

1. Circuit de démodulation d'un signal vidéo de fréquence intermédiaire avec un démodulateur vidéo (1) et avec un circuit de réglage de phase (5) conçu comme une boucle de Costa, un signal de sortie d'un oscillateur (12) commandable prévu dans la boucle de Costa et le signal vidéo de fréquence intermédiaire étant couplés sur le démodulateur vidéo (1),
**caractérisé en ce**
**qu'**il est prévu un inverseur de polarité (2) qui est monté en aval du démodulateur vidéo (1) et à l'aide duquel la polarité du signal vidéo démodulé peut être inversée en fonction d'un signal de commande délivré par le détecteur de polarité (3) et
**que** le détecteur de polarité (3) détermine la polarité du signal de sortie du démodulateur vidéo (1) ou de l'inverseur de polarité (2) et, en fonction de la polarité constatée, commande l'inverseur de polarité (2) à l'aide du signal de commande de telle sorte que le signal vidéo démodulé présente une polarité préalablement déterminée à la sortie de l'inverseur de polarité (2).

2. Circuit selon la revendication 1,
**caractérisé en ce**
**que** le détecteur de polarité (3) détermine la polarité du signal de sortie de l'inverseur de polarité (2).

3. Circuit selon l'une des revendications 1 ou 2,
**caractérisé en ce**
**que** le détecteur de polarité (3) commande l'inverseur de polarité (2) de telle sorte que le signal de sortie de l'inverseur de polarité (2) présente une polarité négative.

4. Circuit selon la revendication 2,
**caractérisé en ce**
**que** le détecteur de polarité (3) présente un comparateur (22) qui lorsque le signal vidéo qui lui est amené dépasse en valeur absolue la valeur d'un signal de comparaison amené au comparateur (22), délivre une impulsion à une bascule bistable D (24) qui modifie sur cette impulsion son état de commutation en fonction duquel le signal de commande est généré.

5. Circuit selon la revendication 4,
**caractérisé en ce**
**que** la tension de comparaison présente approximativement la moitié de la valeur de la tension se produisant en cas de modulation maximale dans un signal vidéo de polarité indésirée.

6. Circuit selon l'une des revendications 1 ou 2,
**caractérisé en ce**
**que** l'inverseur de polarité (3) est conçu comme un multiplicateur.

7. Circuit selon l'une des revendications 1 ou 2,
**caractérisé en ce**
**qu'**il est amené au dispositif un signal de type de modulation qui indique si le signal vidéo est modulé positivement ou négativement et
**que** le détecteur de polarité (3) génère le signal de commande en prenant en considération le type de modulation.

8. Circuit selon l'une des revendications 4 à 7,
**caractérisé en ce**
**que** le signal vidéo dans le détecteur de polarité (3) est amené à un inverseur commutable (21, 25) qui est commandé en fonction du signal de type de modulation et dont le signal de sortie est couplé sur le comparateur (22) et
**qu'**en amont de l'inverseur de polarité (2) est monté un amplificateur vidéo (4) dont l'amplification de tension continue peut varier en fonction du signal du type de modulation.

9. Circuit selon l'une des revendications 4 et 7,
**caractérisé en ce**
**que** la valeur de la tension de comparaison est modifiée en fonction de la valeur du signal de type de modulation et qu'il est monté en amont de l'inverseur de polarité (2) un amplificateur vidéo (4) dont l'amplification de la tension continue est variable en fonction du signal de type de modulation.

10. Circuit selon l'une des revendications 2, 3, 4, 5 et 8,
**caractérisé en ce**
**que** la tension de comparaison présente une polarité positive et que le signal de sortie de l'inverseur de polarité (2) n'est inversé avant le couplage sur le comparateur (22) à l'aide de l'inverseur commutable (21) que lorsque le signal de type de modulation indique un signal vidéo modulé positivement.
